# EUROPÄISCHE PATENTSCHRIFT

(11) **EP 0 169 615 B1**
(45) Veröffentlichungstag und Bekanntmachung des Hinweises auf die Patenterteilung: **05.05.1993**
(21) Anmeldenummer: 85201176.6
(22) Anmeldetag: 12.07.1985
(51) Int. Cl.: H03F 3/217

(54) **Klasse-E-Verstärker**
Class E Amplifier
Amplificateur de classe E

(30) Priorität: 26.07.1984 DE 3427493
(43) Veröffentlichungstag der Anmeldung: 29.01.1986
(73) Patentinhaber: Philips Patentverwaltung GmbH, 22335 Hamburg (DE); Philips Electronics N.V., 5621 BA Eindhoven (NL)
(72) Erfinder: Raets, Hubert, NL-6391 AJ Nieuwenhagen (NL)
(74) Vertreter: Hartmann, Heinrich, Dipl.-Ing.

(56) Entgegenhaltungen:
- DE-A- 2 905 782
- US-A- 3 571 614
- IEEE JOURNAL OF SOLID-STATE CIRCUITS, Band SC-18, Nr. 2, April 1983, Seiten 181-193, IEEE, New York, US; M. KAZIMIERCZUK: "Effects of the collector current fall time on the class E tuned power amplifier"
- Elektrotechnik, Elektronik, VEB-Verlag Berlin, Herausgeber Heinz Gottschalk u. Max Lemberg, 1972, s. 424, 425

## Beschreibung

Die Erfindung bezieht sich auf einen Klasse-E-Verstärker gemäß dem Oberbegriff des Hauptanspruchs.

Aus dem Aufsatz "Class E - A New Class of High-Efficiency Tuned Single-Ended Switching Power Amplifiers" von Sokal und Sokal, IEEE Journal of Solid-State Circuits, Band SC-10, Nr. 3, Juni 1975, Seiten 168 bis 176, ist eine derartige Schaltungsanordnung mit einem Schalttransistor bekannt, dessen Emitter mit Massepotential und dessen Kollektor über eine Drossel mit dem positiven Pol einer Gleichspannungsquelle verbunden ist. Parallel zu der den Hauptstromweg des Schalttransistors bildenden Kollektor-Emitter-Strecke des Transistors ist eine als Spannungsbegrenzelement dienende erste Kapazität sowie eine Reihenschaltung aus einer zweiten Kapazität, einer weiteren Spule und einem Lastwiderstand geschaltet. Über seinen Basisanschluß ist der Transistor mit einem Treiber verbunden, durch den er periodisch in den leitenden und in den nichtleitenden Zustand geschaltet wird. Insbesondere beim Schalten des Transistors in den nichtleitenden Zustand tritt an dessen Kollektor-Emitter-Strecke eine Spannung auf, die durch die erste Kapazität in dem Zeitintervall, während dessen der Transistor von dem leitenden in den nichtleitenden Zustand überführt wird, so lange niedrig gehalten wird, bis der Strom im Kollektor des Transistors vollständig auf Null abgeklungen ist. Die erste Kapazität ist darüber hinaus derart bestimmt, daß die Spannung über der Kollektor-Emitter-Strecke beim nächsten Umschalten des Transistors von dem nichtleitenden in den leitenden Zustand wieder auf Null abgefallen ist. Auf diese Weise werden Verluste im Transistor vermieden und somit der Wirkungsgrad der Schaltung erhöht.

Aus dem Aufsatz "Class E High-Efficiency Tuned Power Oscillator" von Ebert und Kazimierczuk, IEEE Journal of Solid-State Circuits, Band SC-16, Nr. 2, April 1981, Seiten 62 bis 65, insbesondere Abschnitt II, sind Dimensionierungsvorschriften für eine Schaltungsanordnung der eingangs genannten Art zur Minimisierung von Leistungsverlusten im Transistor bekannt. Insbesondere aus den Gleichungen (3) und (9) auf Seite 62 ergibt sich, daß die Größe der ersten Kapazität umgekehrt proportional der Schaltfrequenz gewählt werden muß, um minimale Verlustleistungen im Transistor zu erzielen. Für hohe Schaltfrequenzen muß daher ein sehr kleiner Wert für die erste Kapazität gewählt werden.

Bei einem Transistor, aber auch bei anderen Halbleiterschaltern, tritt in der Regel eine parasitäre Kapazität parallel zum Hauptstromweg auf, die insbesondere für hohe Schaltfrequenzen bei der Wahl des Wertes der ersten Kapazität zu berücksichtigen ist, da sie zu dieser parallel liegt. Es gibt dann einen oberen Grenzwert für die Schaltfrequenz, bei dem die parasitäre Kapazität des Halbleiterschalters allein die Funktion der ersten Kapazität übernimmt, wenn stets eine Dimensionierung der Schaltungsanordnung für minimale Verluste im Halbleiterschalter vorausgesetzt ist. Bei einer weiteren Erhöhung der Schaltfrequenz über diesen Grenzwert hinaus ist dann ein Betrieb der Schaltungsanordnung mit minimalen Verlusten im Halbleiterschalter nicht mehr erreichbar.

Die Erfindung hat die Aufgabe, eine Schaltungsanordnung der eingangs genannten Art derart auszubilden, daß sie für die Anwendung hochspannungsfester Halbleiterschalter mit großen parasitären Kapazitäten parallel zum Hauptstromweg bei Schaltfrequenzen oberhalb ihres oberen Grenzwertes angewendet werden können.

Die Aufgabe wird erfindungsgemäß durch die kennzeichnenden Merkmale des Hauptanspruchs gelöst. Die Kombination aus der parasitären Kapazität und dem Spannungsbegrenzelement weist dann einen gegenüber der parasitären Kapazität verringerten Kapazitätswert auf, der durch Einstellen des induktiven Eingangswiderstands des Spannungsbegrenzelementes derart festlegbar ist, daß die Verlustleistung im Halbleiterschalter minimal wird. Es ist damit möglich, den Bereich, innerhalb dessen der Wert für die Schaltfrequenz festgelegt werden kann, zu hoben Frequenzen hin beträchtlich auszuweiten bei im Vergleich zu niedrigen Werten der Schaltfrequenz unverändert geringen Verlustleistungen und damit hohen Wirkungsgraden. Damit ist es möglich, die Elemente der erfindungsgemäßen Schaltungsanordnung kleiner, leichter und billiger auszuführen.

An dieser Stelle sei bemerkt, daß aus der US-Patentschrift 3 495 183 ein Wechselstromverstärker mit Feldeffekttransistoren bekannt ist, die parallel zu ihren Hauptstromwegen parasitäre Kapazitäten aufweisen und bei denen parallel zu den Hauptstromwegen und damit den parasitären Kapazitäten Reihenschaltungen aus je einem induktiven Element und einem Kondensator angeordnet sind. Das induktive Element enthält einen Ferritkern mit einer Permeabilität, die invers zum Quadrat der Arbeitsfrequenz des Wechselstromverstärkers variiert, und bildet mit der ihm zugeordneten parasitären Kapazität einen Resonanzkreis, der in einem bestimmten Frequenzbereich, in dem die Arbeitsfrequenz variiert, stets auf Resonanz abgestimmt ist und damit stets eine ohmsche Impedanz bildet. Damit ist die Wirkung der parasitären Kapazität des jeweiligen Feldeffekttransistors bei allen auftretenden Arbeitsfrequenzen des Verstärkers völlig aufgehoben.

Nach der Erfindung umfaßt das Spannungsbegrenzelement eine Reihenschaltung aus einem induktiven Element und einem Kondensator. Dabei dient der Kondensator im wesentlichen dazu, einen Gleichstromkurzschluß durch das induktive Element zu verhindern, während der Eingangswiderstand des Spannungsbegrenzelements im wesentlichen durch das induktive Element bestimmt ist.

Nach einer Weiterbildung der Erfindung ist das induktive Element mit einem Abschnitt einer Leitung ausgebildet. Eine derartige Schaltungsanordnung wird vorteilhaft bei hohen Schaltfrequenzen eingesetzt. Ein derartiges induktives Element kann dann einfach und genau durch Anpassung der Abmessungen, beispielsweise der Leitungslänge, dimensioniert werden. Vorteilhaft ist auch eine Ausführung einer derartigen Leitung mit einem vorzugsweise streifenförmigen, leitenden Belag, der beispielsweise mit den übrigen leitenden Verbindungen für die Schaltungsanordnung auf einer Platine zusammengefaßt und gemeinsam hergestellt werden kann.

Einige Ausführungsbeispiele der Erfindung sind in der Zeichnung dargestellt und werden im nachfolgenden näher beschrieben. Es zeigen
- Fig. 1: eine Schaltungsanordnung nach dem Stand der Technik,
- Fig. 2: eine Ausführungsform der Erfindung.

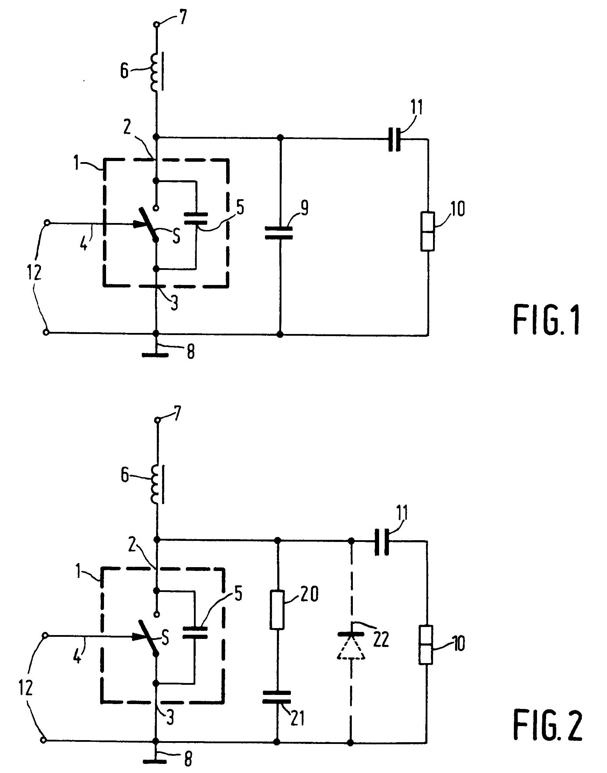

Fig. 1 zeigt schematisch eine Verallgemeinerung einer aus dem eingangs genannten Aufsatz von Sokal und Sokal bekannten Schaltungsanordnung. Darin ist ein Halbleiterschalter 1 schematisch mit einem zwischen zwei Anschlüssen 2 und 3 ausgebildeten Hauptstromweg, der durch einen Schalter S in den leitenden und in den gesperrten Zustand geschaltet werden kann, dargestellt. Der Schalter S wird über einen Steueranschluß 4 umgeschaltet. Parallel zum Schalter S liegt eine parasitäre Kapazität 5.
In dem genannten Aufsatz von Sokal und Sokal wird der Halbleiterschalter 1 durch einen bipolaren Transistor vom npn-Typ gebildet, dessen Kollektor den ersten der beiden Anschlüsse 2, dessen Emitter den zweiten der beiden Anschlüsse 3 und dessen Basis den Steueranschluß 4 bilden. Die in den leitenden und in den nichtleitenden Zustand schaltbaren Halbleiterschichten des Transistors bilden den Schalter S, und die Kollektor-Emitter-Kapazität bildet die parasitäre Kapazität 5.

In der Schaltungsanordnung nach Fig. 1 ist der erste Anschluß 2 über eine Drossel 6 mit dem positiven Pol 7 einer Gleichspannungsquelle verbunden, während der zweite Anschluß 3 an einem Massepotential führenden Masseanschluß 8 liegt. Parallel zum Halbleiterschalter 1 sind eine ein Spannungsbegrenzelement bildende erste Kapazität 9 sowie eine induktive Last 10 angeordnet. Die Last 10 enthält einen induktiven und einen ohmschen Widerstandsanteil und ist mit einer zweiten Kapazität 11 in Reihe geschaltet. Über zwei Eingangsanschlüsse 12, von denen einer mit dem Masseanschluß 8 und ein zweiter mit dem Steueranschluß 4 des Halbleiterschalters 1 verbunden ist, wird der Schaltungsanordnung eine Steuerspannung zum Umschalten des Halbleiterschalters 1 in den leitenden oder in den nichtleitenden Zustand zugeführt.

Bei der Dimensionierung der Schaltungsanordnung nach Fig. 1 gewinnt, insbesondere bei hohen Schaltfrequenzen der über die Eingangsanschlüsse 12 zugeleiteten Steuerspannung, die parasitäre Kapazität im Halbleiterschalter 1 zunehmend Einfluß und muß bei der Wahl des Wertes der ersten Kapazität 9 berücksichtigt werden. Der Wert der ersten Kapazität ist derart zu wählen, daß ihre Summe mit dem Wert der parasitären Kapazität 5 gerade den für minimale Verluste im Halbleiterschalter 1 zu wählenden Wert der Kapazität des Spannungsbegrenzelements entspricht. Wird dieser bei Erreichen des oberen Grenzwerts für die Schaltfrequenz gleich dem Wert der parasitären Kapazität 5, kann die erste Kapazität 9 theoretisch entfallen. Bei einer weiteren Erhöhung der Schaltfrequenz ist jedoch ein Betrieb der Schaltungsanordnung mit minimaler Verlustleistung nicht mehr möglich, da allein der Wert der parasitären Kapazität 5 einen zu großen Kapazitätswert für das Spannungsbegrenzelement darstellt.

Fig. 2 zeigt ein Ausführungsbeispiel für eine erfindungsgemäße Schaltungsanordnung, in der mit Fig. 1 übereinstimmende Teile mit gleichen Bezugszeichen dargestellt und entsprechend zu Fig. 1 beschrieben sind. Die in Fig. 1 als Spannungsbegrenzelement verwendete erste Kapazität 9 ist in der Schaltungsanordnung nach Fig. 2 durch eine Reihenschaltung aus einem induktiven Element 20 und einem Kondensator 21 ersetzt, die derart dimensioniert sind, daß die Impedanz des induktiven Elements bei der Schaltfrequenz gegenüber der Impedanz des Kondensators 21 überwiegt. Während also der Kondensator 21 überwiegend einen Gleichstromkurzschluß zwischen dem positiven Pol 7 der Gleichspannungsquelle und dem Masseanschluß 8 verhindert, bildet das induktive Element 20 zusammen mit der parasitären Kapazität 5 eine als neues Spannungsbegrenzelement wirkende Anordnung mit einem gegenüber der parasitären Kapazität 5 verringerten Kapazitätswert.

Parallel zum Halbleiterschalter 1 kann bei der Schaltungsanordnung nach Fig. 2 gegebenenfalls eine Diode 22 angeordnet sein, die verhindert, daß der erste Anschluß 2 des Halbleiterschalters 1 gegenüber dem Masseanschluß 8 negatives Potential annimmt, und die somit Spannungsspitzen bzw. Überschwinger ableitet.

Bei der erfindungsgemäßen Schaltungsanordnung kann der Halbleiterschalter 1 als Bipolartransistor vom npn- oder vom pnp-Typ, als Feldeffekttransistor, als Thyristoranordnung oder in ähnlicher Weise ausgebildet sein. Auch Kombinationen derartiger Halbleiterschalter, beispielsweise eine Reihenschaltung aus einem Bipolartransistor und einem Feldeffekttransistor (Bimos), können als Halbleiterschalter 1 eingesetzt werden. Der Hauptstromweg dieser Schalter ist dann jeweils zwischen den Anschlüssen 2 und 3 anzuordnen, während ihre Steuerelektroden, beispielsweise Basis- oder Gate-Anschlüsse, mit dem Steueranschluß 4 zu verbinden sind. Bei Verwendung einer Reihenschaltung beispielsweise aus einem bipolaren Transistor und einem Feldeffekttransistor wird dann der bipolare Transistor mit seinem Kollektor mit dem ersten Anschluß 2 und mit seinem Emitter mit dem Drain-Anschluß des Feldeffekttransistors verbunden, dessen Source-Anschluß an den Masseanschluß 8 gelegt ist. Die Basis des bipolaren Transistors wird über einen Vorspannungskondensator mit dem Masseanschluß 8 verbunden, während der Steueranschluß 4 mit dem Gate-Anschluß des Feldeffekttransistors verbunden wird.

## Patentansprüche

1. Klasse-E-Verstärker mit wenigstens einem Halbleiterschalter, der einen Strom durch eine Last, die einen induktiven Blindwiderstand enthält, mit einer Schaltfrequenz periodisch mit seinem abwechselnd leitend bzw. nichtleitend geschalteten Hauptstromweg schaltet, der eine parasitäre Kapazität aufweist und zu dem parallel zum Begrenzen der an ihm anliegenden Spannung ein Spannungsbegrenzelement angeordnet ist,
dadurch gekennzeichnet, daß das Spannungsbegrenzelement (20, 21) eine Reihenschaltung aus einem induktiven Element (20) und einem Kondensator (21) umfaßt und bei der Schaltfrequenz einen induktiven Eingangswiderstand aufweist.

2. Klasse-E-Verstärker nach Anspruch 1,
dadurch gekennzeichnet, daß das induktive Element (20) mit einem Abschnitt einer Leitung ausgebildet ist.

## Claims

1. A class-E amplifier comprising at least one semiconductor switch which switches periodically a current through a load comprising an inductive dummy resistor with a switching frequency by means of its main current path switched alternately to the conductive and the non-conductive state, which has a parasitic capacitance, and which has connected parallel to it a voltage-limiting element for limiting the voltage applied to it,
characterized in that the voltage-limiting element (20, 21) comprises a series arrangement of an inductive element (20) and a capacitor (21) and has an inductive input resistance at the switching frequency.

2. A circuit arrangement as claimed in Claim 1, characterized in that the inductive element (20) is provided with a section of a lead.

## Revendications

1. Amplificateur de classe E muni au moins d'un commutateur semiconducteur commutant à travers une charge munie d'une réactance inductive un courant avec une fréquence de commutation, périodiquement avec son trajet de courant principal commuté alternativement de manière à être conducteur ou non conducteur, présentant une capacité parasitaire et auquel est disposé en parallèle un élément limiteur de tension pour limiter la tension appliquée à celui-ci, caractérisé en ce que l'élément limiteur de tension (20, 21) comporte un montage en série constitué d'un élément inductif (20) et d'un condensateur (21) et en ce qu'il présente une résistance d'entrée inductive lors de la fréquence de commutation.

2. Amplificateur de classe E selon la revendication 1, caractérisé en ce que l'élément inductif (20) comporte un morceau de conducteur.
